Europäisches Patentamt

European Patent Office

Office européen des brevets

(19)

(11) Publication number: 0 197 519
A2

(12) **EUROPEAN PATENT APPLICATION**

(21) Application number: 86104598.7

(22) Date of filing: 04.04.86

(51) Int. Cl.⁴: G03F 7/02

(30) Priority: 10.04.85 US 721629
28.10.85 US 791867

(43) Date of publication of application:
15.10.86 Bulletin 86/42

(84) Designated Contracting States:
DE FR GB

(71) Applicant: International Business Machines
Corporation
Old Orchard Road
Armonk, N.Y. 10504(US)

(72) Inventor: Klymko, Paul W.
13-14 Loudon Drive
Fishkill New York 12524(US)
Inventor: Lyons, Christopher F.
408 Beaver Road
Lagrangeville New York 12540(US)
Inventor: Moreau, Wayne M.
10 Lydia Drive
Wappingers Falls New York 12590(US)

(74) Representative: Kreidler, Eva-Maria, Dr. rer.
nat.
Schönaicher Strasse 220
D-7030 Böblingen(DE)

(54) **Process for masking and resist formation.**

(57) A method of producing image masks comprising, in one embodiment providing enhanced opacity in a novolac based imaging mask by providing a substrate with a deep bottom U.V. resist bottom layer sensitive to wavelengths in the range from 200 to below 280 nm which can either be an aqueous base developable resist layer or an organic solvent developable resist layer with a novolac resin based top resist layer, imagewise exposing and then developing the novolac resin based top resist layer for conversion thereof into an imaging mask, exposing with radiation having wavelengths in the range of about 280 to about 310 nm followed by imagewise exposing the bottom resist layer through the imaging mask with U.V. wavelengths in the range of 200 to just below 280 nm, developing the bottom resist layer to form an image conforming to the image of the imaging mask. and in another embodiment providing an all aqueous-base developable system by providing a substrate with a bottom resist layer of an aqueous-base developable material and thereon a top resist layer of an aqueous-base developable material wherein the bottom and top resist layer materials are sensitive to different radiation wavelengths in the same wavelength range, imagewise exposing and then developing the top resist layer using an aqueous-base developer for conversion thereof into an imaging mask, followed by subsequently imagewise exposing developing the bottom resist layer to form an image conforming to the image of the imaging mask.

# PROCESS FOR MASKING AND RESIST FORMATION

This invention relates to portable-conformable mask technology. More specifically, in one embodiment this invention relates to a method of providing enhanced opacity in a novolac-based imaging mask employed therein. In another embodiment, this invention relates to an all-aqueous system developable portable-conformable mask process.

A portable conformable mask (PCM) technique is known for producing high aspect ratio resist images which are not sensitive to underlying topography. This technique is used for subtractive etch and lift-off metallization processes. The basis of this technique disclosed by Lin (as set forth in U.S. Patent 4,211,834) is that a novolac resist image may be employed as a mask for a deep U.V. flood exposure of an underlying deep U.V. resist. The importance of the PCM technique lies in the fact that it is the only method presently known for creating topography-insensitive, micron and sub-micron sized high aspect ratio resist images without the use of reactive ion etching. The technique is desirable since reactive ion etching processes are complex and costly and it is difficult to maintain reproducible controls with reactive ion etching.

Novolac resins mixed wtih specific sensitizers are useful in resist compositions and are used in the PCM art. These resists are used on an underlayer such a described in U.S. Patent 4,078,569. Disclosed therein is a resist which is sensitive to radiation in the electron and deep ultraviolet regions.

A significant limitation of PCM process using novolac-based resists is that the novolac-based resists employed are not completely opaque in the deep U.V. region.

Thus, a significant transmission "window" exists at 240-280 nm in these materials. As a result, the transmission of light by novolac-based imaging reists in that transmission window limits the overall contrast available in PCM processes. Therefore, films thicker than 0.5 μm are required which limits resolution.

Consequently, aspect ratios are reduced, adhesion between layers is adversely affected and deep U.V. resist selection is severely limited.

For electron beam printing of PCM bilayer resists, thinner top layers reduce the interproximity effect, i.e. resolution is enhanced allowing smaller features.

Within the art, two approaches are currently used to overcome this masking deficiency with conventionally known two layer resists in the PCM art. The first is by careful filtration of deep U.V. flood exposure wavelengths to eliminate wavelengths greater than 240 nm. This approach is limited to deep U.V. resists responsive at less than 240 nm. These deep U.V. resists responsive at less than 240 nm are primarily insensitive acrylate resists. A second proposed solution is the addition of a material to the novolac resist which increases its opacity at 240-280 nm.

The use of dielectric mirrors to filter out and eliminate wavelengths greater than 240 nm has several drawbacks. With this technique of wavelength filtration, the efficiency of the mirror is relatively low and consequently a large portion of the available radiation is wasted. This results in increased exposure times. Moreover, dielectric mirrors are expensive and fragile when used in a manufacturing process.

Relative to the second proposed solution, the addition of 240-280 nm absorbing materials to the novolac resist is less desirable than the first potential solution. These additional materials degrade the lithographic performance of the resist because of the changes in solubility and/or optical properties of the resist film due to the presence of such additives. Some of these additives also reduce the shelf life of the resist solution used in producing the film.

A PCM technique using a polymethyl methacrylate (PMMA) resist as a deep U.V. photoresist covered with a novolac resist as a near U.V. photoresist for a PCM resist is known, e.g., as described in U.S. Patent 4,211,834. In this technique, the PCM resist is imagewise exposed and the upper level novolac near U.V. photoresist is then developed. Since the upper level novolac near U.V. photoresist must act as a conformal contact mask during subsequent exposure of the PMMA deep U.V. photoresist, the novolac resin image areas remaining after development must be such that they also absorb strongly in the radiation region to which PMMA is sensitive. This permits the underlying PMMA deep U.V. photoresist to be exposed through the novolac conformable mask to ultimately form a photoresist pattern on the underlying substrate.

Matthews and Wilmott report ("Stabilization of Single Layer and Multilayer Resist Patterns to Aluminum Etching Environments" presented at the SPIE Conference; Optical Microlithography III, Santa Clara, California, March 14-15, 1984) variation on the PCM technique and this variation is described in this report to be an improvement in the PCM technique discussed above.

In this variation, after development of the novolac resist top layer resist image, but prior to exposure to deep U.V. for pattern transfer to the deep U.V. PMMA resist layer, a specific U.V. thermal treatment step is employed with the top layer novolac resist being cross-linked as a result. This U.V. and thermal treatment step involves exposure to U.V. illumination of wavelengths between 260 nm and and under 320 nm with a thermal treatment during U.V. exposure optionally followed by a hard baking step depending on the thermal treatment temperature used during this exposure.

However, even this variation does not result in a PCM resist having all of the properties and characteristics desired. Moreover, in this technique, PMMA is used as the underlayer and an organic solvent is used for development of the underlayer. As a result of the U.V. exposure coupled with a thermal treatment, an organic solvent insoluble interfacial layer is formed rendering the technique inoperable without additional steps being employed such as plasma etching to remove the insoluble interfacial layer prior to organic solvent development of the underlying PMMA layer. Disadvantages such as the necessity for a separate step to remove the insoluble interfacial layer and the requirement for an organic solvent development step remain. Thus, improvements in known PCM techniques wherein a minimum number of processing steps can be employed or wherein all-aqueous development can be used are earnestly desired.

Given the deficiencies of the prior art, it is an object of this invention to provide a technique of enhancing the portable conformable mask technique throughout by a greater utilization of deep U.V. energy.

A further object of this invention is to provide a PCM technique wherein the layers of the PCM are developable with aqueous developers thereby reducing cost, avoiding the necessity for organic solvent recovery, avoiding environmental pollution problems and minimizing worker safety problems.

Another object of this invention is to provide an all aqueous base developable PCM process wherein the components used in the layers thereof have higher thermal starting stability and thus are more resistant to thermal flow.

The method of this invention permits a greater selection of commercially available high sensitivity deep U.V. resists allowing the portable conformable mask process to attain wider manufacturing use;

The PCM technique of this invention eliminates the prior art formation of interlayer residues during processing and to thereby provide improved resolution in the portable conformable mask produced;

and permits the use of thinner imaging layers, thereby enhancing overall resolution potential in processing utilizing the portable conformable mask technique.

The PCM technique of this invention can be used to produce capped resist images in a simple and straight forward manner.

An additional advantage of this invention is that in this PCM technique a broader range of different resist materials can be used to produce a PCM and a greater latitude exists in the nature of the exposure and irradiation used in producing a resist image in a PCM.

The objects and advantages of this invention are attained in an embodiment of the invention by exposing a PCM two-layer imaging mask, in which the top or upper layer contains a novolac resin, to radiation in the wavelength range of about 280 to about 310 nm prior to flood exposure of an underlying deep U.V. resist and so selecting the nature of the layers in the imaging mask that advantageous results are obtained. This improves the opacity of the mask in the window, that is, in the wavelength range of about 240 to about 280 nm.

Thus, in accordance with a further embodiment of this invention, a method is provided to produce enhanced opacity in a novolac-based imaging mask where the method comprises

(a) providing a substrate having thereon a deep U.V. resist layer sensitive to wavelengths in the range of about 200 to about 280 nm as a (bottom) first resist layer and a novolac resin based (top) second resist layer on the first resist layer;

(b) imagewise exposing the first resist layer;

(c) developing the first resin layer for conversion into an imaging mask;

(d) as necessary exposing the imaging mask to radiation having wavelengths in the range of about 280 to about 310 nm;

(e) imagewise exposing the bottom resist layer through the imaging mask so obtained with U.V. wavelengths in the range of about 200 to just below about 280 nm; and

(f) developing the bottom resist layer to form an image corresponding to the image of the imaging mask.

More specifically, the method of this invention according to claim 1 provides a method of enhancing the opacity of a novolac-based imaging mask comprising

(a) providing a substrate with an aqueous base developable deep U.V. bottom resist layer sensitive to wavelengths in the range from about 200 to below about 280 nm and with a novolac resin based top resist layer;

(b) imagewise exposing the top resist layer;

(c) developing the imagewise exposed top resist layer for conversion thereof into an imaging mask;

(d) imagewise exposing the bottom resist layer through the imaging mask with U.V. light containing wavelengths in the range of about 200 to about 280 nm; and

(e) developing the bottom resist layer with an aqueous base developer to form an image conforming to the image of an imaging mask.

Advantageous results are obtained where between step (c) and step (d), the method also includes exposing the imaging mask with radiation having wavelengths in the range of about 280 to about 310 nm.

According to claim 7, this invention provides a method of enhancing the opacity of a novolac-based imaging mask comprising:

(a) providing a substrate with an organic solvent developable deep U.V. resist bottom layer sensitive to wavelengths in the range from about 200 to below about 280 nm and with a novolac resin based top resist layer;

(b) imagewise exposing the top resist layer;

(c) developing the imagewise exposed top resist layer for conversion thereof into an imaging mask;

(d) exposing the imaging mask with radiation having wavelengths in the range of about 280 to about 310 nm;

(e) imagewise exposing the bottom resist layer through the imaging mask with U.V. light containing wavelengths in the range of about 200 to about 280 nm; and

(f) without further treatment of the imaging mask, developing the bottom resist layer with an organic solvent developer to form an image conforming to the image of the imaging mask.

According to claim 10, this invention provides an all aqueous developable method of producing a resist image comprising

(a) providing a substrate with a bottom layer of a first resist material sensitive to wavelengths in the range of about 200 to about 300 nm and a top layer of a second resist material sensitive to wavelengths in the range of about 300 to about 500 nm, wherein

(i) the first resist material and the second resist material each becomes developable in an aqueous base developer upon exposure to radiation or upon exposure to radiation followed by thermally treating the resist material,

(ii) the top layer resist material uniformly coats and adheres with the bottom layer resist material,

(iii) the first resist material and the second resist material are sensitive to radiation in substantially different wavelength ranges or are differentially sensitive to radiation in the same wavelength range with the second resist material being at least 100 times more sensitive to such radiation than the first resist material and

(iv) after exposure and development of the top layer, the top layer resist material acts as an effective mask for radiation of wavelengths to which the bottom layer resist material is sensitive;

(b) imagewise exposing the top resist layer to radiation within a wavelength range to which the top layer resist material is sensitive;

(c) developing the imagewise exposed top resist layer with aqueous-base developer for conversion thereof into an imaging mask;

(d) imagewise exposing the bottom resist layer through the imaging mask to radiation within a wavelength range to which the bottom layer resist material is sensitive; and

(e) developing the bottom resist layer with an aqueous-base developer to form an image conforming to the image of the image mask.

In the above third embodiment, where desired, a blanket exposure to radiation in the wavelength range of about 280 to about 310 nm can be employed between step (c) and step (d) to improve the opacity of the top resist as a mask image to the underlying bottom resist layer.

This invention will be described in greater detail by referring to the attached drawings and a detailed description of embodiments of this invention.

Fig. 1 is a plot of absorbance as a function of wavelength illustrating the change in absorption as a function of irradiation in a novolac resin used in one embodiment of this invention.

Fig. 2 is a plot of absorption versus wavelength demonstrating the change in the absorption spectrum as a function of irradiation or a combination of plasma hardening and a thermal treatment of a resist composed of a novolac resin and a polyolefin sulfone sensitizer used in one embodiment of this invention.

Fig. 3 is a plot of absorption versus wavelength demonstrating the change in the absorption spectrum of a 0.5 micron film of a novolac photoresist composed of a novolac resin and a diazoquinone sensitizer used in one embodiment of this invention.

## DESCRIPTION

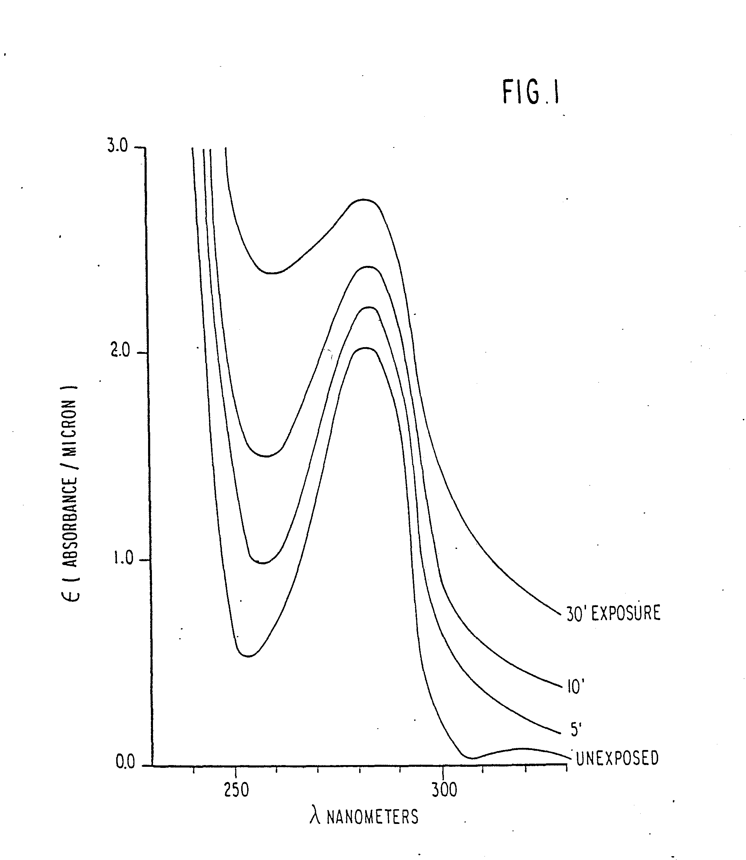

Referring now to Figs. 1-3, the effect of U.V. exposure on the 240-280 nm absorbance of a novolac resin and two novolac resists is illustrated. As illustrated, following exposure the films are essentially opaque to wavelengths below 300 nm.

Suitable examples of aqueous base developable novolac resins as resist materials which can be employed in the first and second embodiments of this invention include novolac resins, for example, the condensation products of phenol or alkyl - ($C_1$-$C_6$) substituted and halogen-substituted phenols (e.g., cresols, etc.) resorcinol, pyrogallol, with aldehydes or aldehyde precursors such as formaldehyde, acetaldehyde, acetone, acrolein, benzaldehyde, 1,3,5-trioxane and also addition polymers of hydroxy styrene and the like. Suitable aqueous base developable resins are those with molecular weights of about 300 to about 100,000, preferably 300 to 20,000.

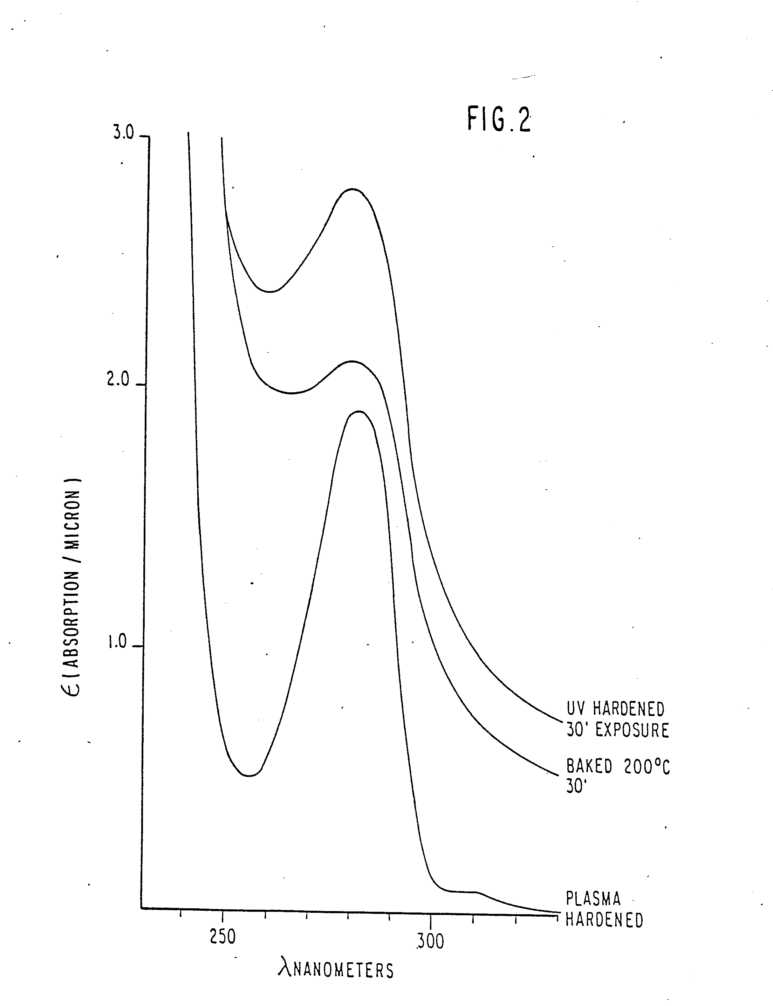

The novolac resin compositions which can be used to produce the novolac based top resist layer employed in these embodiments of this invention generally include a photosensitizer, e.g., of the 1,2-diazonaphthoquinone-5-sulfonate type, such as the 1-oxo-2-diazo-napthalene-5-sulfonic acid ester of 2,3,4-trihydroxybenzophenone, e.g., as disclosed in U.S. Patents 3,046,118, 3,046,121, 3,106,465; 3,201,239; 3,666,473, to increase sensitivity to the radiation of exposure. Suitable commercially available novolac-based U.V. photoresists of this type are AZ 1350 (trade name for a resist comprising a novolac resin and a diazoquinone photosensitizer commercially available from Azoplate) and HPR 204 (trade name for a resist comprising a novolac resin and a diazoquinone photosensitizer commercially available from Hunt Chemical). Other resists utilizing different combinations of novolac resins and different photosensitizers can be employed, if desired, in this invention. For example, in Fig. 2, a novolac resist with a polyolefin sulfone sensitizer, e.g., as described in U.S. Patent 4,398,001, polymethylallyl ether-methyl pentene sulfone bipolymer was employed. A commercially available example of this class of novolac composition is RE 5000P - (trade name for an electron beam resist comprising a novolac resin and poly-2-methyl pentene sulfone commercially available from Hitachi).

Suitable materials which can be used as the bottom deep U.V. resist layer of the mask imaging material used in the first and second embodiments of this invention include those materials which are soluble in organic solvent developers and those materials which are soluble in aqueous base developers.

More specifically suitable examples of resist materials developable in organic solvent developers which can be used in these embodiments of this invention include polymethylmethacrylate - (PMMA) polymers, polymethylisopropenyl ketones, poly-t-butyl methacrylates and other polymethacrylate copolymers.

Exemplary materials developable in aqueous base developers which can be employed in these embodiments of this invention as the bottom deep U.V. resist layer include methacrylate terpolymers such as methyl methacrylate/methacrylic acid/methacrylic anhydride terpolymer (e.g., as disclosed in U.S. Patent 3,087,659); aliphatic imide polymers such as polydimethyl glutarimide; other acrylic acid polymers; polymethyl methacrylatemethacrylic acid polymers; itaconic acid polymers such as poly-dimethyl itaconic acid; and poly-(hydroxystyrene).

Both positive and negative resist materials can be used for the top resist layer, as desired, such as azide-polyvinyl phenols (e.g., as disclosed in U.S. Patents 4,268,603, 4,148,655, etc.) (such as R93000N and RE2000N available from Hitachi Chemical), diazoquinone phenolics or novolacs - (such as AZ 1350 available from Azoplate), etc.

Where desired when the top resist layer is to be exposed, the bottom resist layer can be dyed, e.g., with a dye. Suitable characteristics of this dye are thermal stability and ability to absorb the wavelength of U.V. light used for top layer resist exposure. Suitable specific examples include coumarin dyes such as coumarin 6, coumarin 7 and coumarin 30 available from Kodak.

In the embodiment of the all aqueous developable PCM process of this invention, suitable resist materials which can be used to form the upper resist layer comprise polymeric materials which are used in combination with a sensitizer or photoactive component. Suitable polymeric materials may be selected from novolac resins, polyvinyl phenol-based polymers, and polymers which are converted to a polyvinyl phenol upon irradiation or a combination of irradiation and thermal treatment, in the presence of a photoactive component added to the polymer.

Specific examples include diazoquinone derivative sensitized novolac resins. Examples of suitable resist materials which comprise polyvinyl phenol and bis aryl azides are described in U.S. Patent 4,268,603. Examples of polymers converted to a polyvinyl phenol upon irradiation and thermal treatment in the presence of an aryl onium salt photoactive component are poly(p-tert-butoxycarbonyloxystyrene), poly(tert-butyl p-vinylbenzoate), poly(p-tert-butoxycarbonyloxy-2-methylstyrene), poly(tert-butyl p-isopropenyloxyacetate), and poly-(tert-butyl methacrylate), e.g., as disclosed in U.S. Patent 4,491,628.

Suitable resist materials for the bottom layer of the imaging material which can be used in the embodiments of the all aqueous developable PCM process of this invention include a polymer or the polymer comprises at least portions of a polymer selected from the group consisting of

(1) a polymer which contains a carboxylic acid group and which upon irradiation becomes aqueous-base developable such as a terpolymer of methyl methacrylate, methacrylic acid and methacrylic anhydride;

(2) a polymer comprising an acid anhydride group wherein upon irradiation the anhydride hydrolyzes, or after irradiation, in the presence of the aqueous base developer, the anhydride hydrolyzes to provide an acid such as a copolymer of methacrylic anhydride and acrylic anhydride;

(3) a polymer comprising an imide group which upon irradiation becomes aqueous-base developable such as a polyglutarimide and a polymaleimide; and

(4) a polymer which upon irradiation generates a phenolic or hydroxy group such as o-nitrobenzaldehyde derivatives, polymers capable of photo-Fries rearrangement, and the onium salt-"t-boc" system described in U.S. Patent 4,491,628.

Various sensitizers can be used to enhance the radiation sensitivity of the polymers suitable for use in this invention, but use of a sensitizer is not necessary in most cases, since with the exception of the onium salt-"t-boc" polymers of the group - (4), the aqueous base developable polymers are per se photosensitive.

The mask material which can be used in embodiments of this invention can be easily prepared using the above described materials. More specifically, a substrate such as an oxidized silicon wafer is first coated with a uniform layer of the resist material for the bottom resist layer in a thickness of about 0.5 to about 5 μm, preferably 1 to 3 μm, using conventional coating techniques such as spin coating, followed by drying. This is then followed by coating the bottom resist layer with a layer of the resist for the top layer material in a thickness of about 0.3 to about 1.5 μm, preferably 0.5 to 1.0 μm. Suitable techniques for coating the top resist layer include spin coating, followed by drying.

After the mask material of this invention is produced, the material is then exposed in an imagewise manner, e.g., using a chrome-on-glass master as an image, to radiation to which the top layer is senstive. A suitable wavelength of the radiation used for this exposure ranges from about 300 nm to below about 450 nm, preferably in the range of 350 nm to 440 nm. Suitable sources of radiation which can be used for exposure to wavelengths in this range include a mercury lamp, a mercury-xenon lamp, etc. Alternatively, the top layer can be imagewise exposed to electron beam radiation or X-rays. Use of electron beams or X-rays for this exposure step is advantageous where the top resist layer and the bottom resist layer are differentially sensitive to radiation.

After this exposure step of the resist top layer, the mask material is then developed in an aqueous base developer having a pH of about 12 to about 13. Suitable examples of aqueous base developers which can be used in this invention include aqueous solutions of potassium hydroxide, sodium hydroxide, tetramethyl ammonium hydroxide, sodium silicate, sodium phosphate, etc. These developers are commercially available as AZ Developer from Azoplate and Microporit 2401 from Shipley. The exposed areas of the top resist layer as a result of the exposure are rendered soluble in the aqueous base developer and upon contact therewith are removed uncovering in those areas removed the bottom resist layer lying thereunder. Naturally, those areas removed in this development will be dependent on whether the top resist layer is a positive resist or a negative resist.

As a result of this exposure and development of the top resist layer, a mask image corresponding to the original resist image is formed in the top layer to form a mask for the bottom resist layer lying under the top layer.

In the next step of the process of this invention where greater opacity to deep U.V. radiation of the resist image formed in the top layer for masking the bottom layer is desired, e.g., where a thin novolac based top resist layer (e.g., less than about 1 micron on thickness) is employed, the resulting image mask is exposed to radiation having a wavelength of about 280 to about 310 nm, preferably 280 to 320 nm at about 20°C to about 200°C. For example, a blanket exposure can be used.

Suitable sources providing radiation in this wavelength range include a mercury-xenon lamp, a mercury lamp, and the like. This exposure causes the remaining image areas of the top resist layer to become opaque to deep U.V. exposure, i.e., to radiation in the deep U.V. radiation region. A suitable exposure amount for this exposure step is about 1 to about 20, preferably 5 to 20, joules per square centimeter.

Subsequent to the first image exposure step or exposure to radiation of about 280 to about 310 nm for opacifying purposes as described above, a second imagewise exposure step is employed. Radiation which is suitable for this exposure is radiation to which the bottom resist layer is sensitive. For example, where the bottom resist layer is a deep U.V. resist layer, a suitable wavelength of radiation for this exposure ranges from about 200 to about 280 nm, preferably 200 to 240 nm. Suitable sources of radiation with wavelengths in this range include mercury arc lamps, and the like.

As a result of this exposure, the bottom resist layer is rendered developable in a developer. Where the bottom resist layer is developable in an aqueous base developer, suitable aqueous base developers which can be used are those having a pH in the range of 12.5 to 13.5. Exemplary aqueous base developers which can be used include aqueous solutions of sodium hydroxide, potassium hydroxide, tetramethylammonium hydroxide, sodium phosphate and sodium silicate. A suitable time and temperature for this development ranges from about 1 minute to about 10 minutes at about 10°C to about 25°C, respectively. Where the bottom resist layer is developable in an organic solvent developer, suitable developers which can be used include those conventionally used in the art. A suitable time and temperature for this development ranges from about 10 seconds to about 2 minutes at about 10°C to about 25°C, respectively.

As a result of the procedures described above, a mask on the substrate is thereby formed.

Turning now to the accompanying figures, these figures illustrate the improvement in opacity achieved in an embodiment of the process of this invention where a deep U.V. PCM technique is employed using, e.g., a novolac resin as the top resist layer.

The data of Fig. 1 was obtained with fairly long exposure times on the order of 5 to 30 minutes using a low powered lamp (250W). However, processing times can be reduced by a factor of approximately 10 utilizing more high powered lamp designs. The design of an exposure system for the express purpose of reducing processing times is therefore attainable.

Fig. 2 illustrates that a similar change can be induced thermally using a novolac/polyolefin sulfonic resist. The combination of U.V. exposure and thermal treatment can therefore further reduce processing times.

Fig. 3 illustrates the effect of this embodiment of the process of this invention on a thin film (0.5 μm) of a resist comprising a novolac resin (i.e., a cresol-formaldehyde condensate, molecular weight about 6000) plus a napthoquinone diazide photosensitizer.

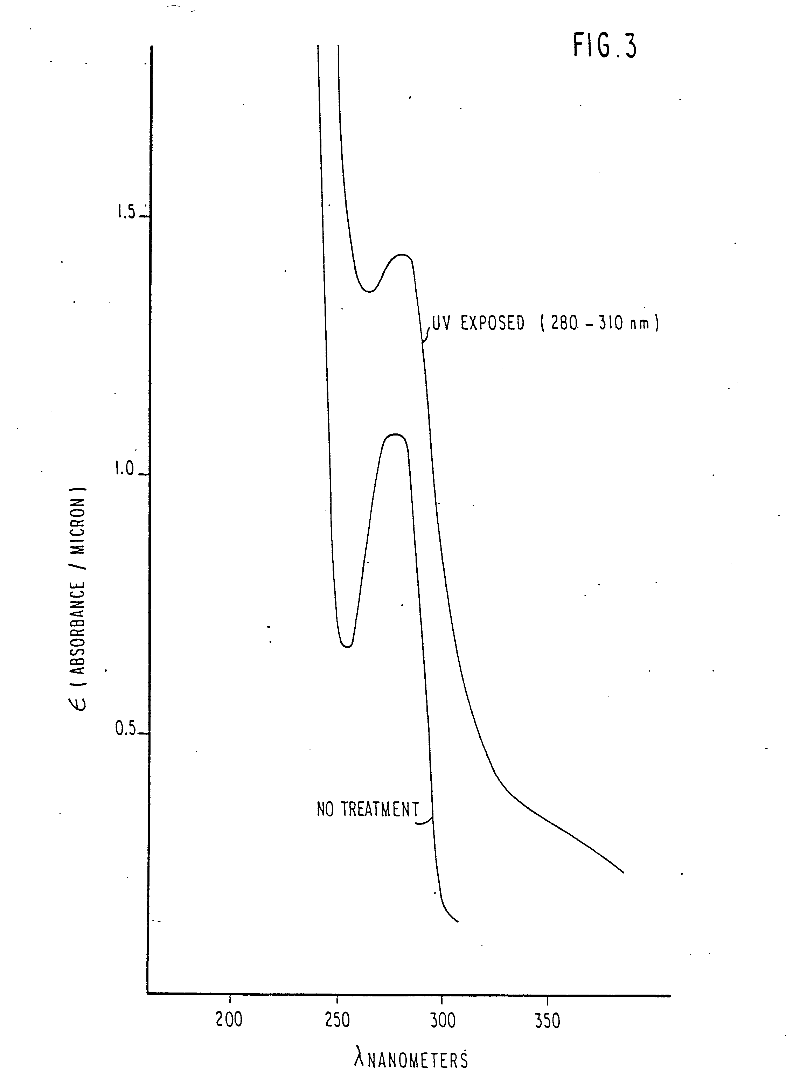

0.5 μm treated and untreated films of this novolac resist composition (treatment at 3 min. exposure on a high intensity U.V. source of about 60 mW/cm² at 300 nm with a filter to eliminate wavelengths below 280 μm) were used as a mask for a 200 to 280 μm exposure of an acrylic terpolymer (a terpolymer of methylmethacrylate, methacrylic anhydride and methacrylic acid; molar ratio: 70:15:15) deep U.V. resist (see, U.S. Patent 4,087,569). The contrast of this exposure was measured by measuring the dissolution rate of the masked and unmasked portions of the film in a developer comprising 2-ethoxyethanol. The sample which had a 280 -310 nm treated mask present showed an increase in contrast (exposed to unexposed solubility ratio) of 32% compared to the non-treated sample. Fig. 1 (resin), Fig. 2 (resin and polyolefin sulfone sensitizer) and Fig. 3 (resin and napthoquinone diazide sensitizer) show that the effect is a result of the properties of the resin and is considered universal for all novolac-like resist systems.

In practicing the above-described embodiments of this invention, the deep U.V. masking ability of a novolac resist is improved. This occurs without any alteration of the lithographic performance of the resist. The technique eliminates the need for the use of expensive, inefficient dielectric mirrors in the flood exposure step of deep U.V. PCM processes using a novolac top layer resist.

While these embodiments of this invention have been defined relative to the examples and materials disclosed herein, the opacification is applicable to any PCM configuration where a novolac resist is employed as a mask for exposure of an underlying resist which is in itself sensitive between about 200 to about 280 nm.

In the embodiments of the process of this invention using a novolac resist as the top resist layer and where the bottom resist layer is an organic solvent developable resist layer such as that of polymethyl methacrylate, after the imagewise exposure to radiation with wavelengths of about 200 to 280 nm, the resist material is developed with an organic solvent developer without treating the material to any additional processing such as a thermal treatment, e.g., soft or hard baking. This permits high resolution sub-micron images to be obtained. An intervening thermal treatment thus is not employed because of a degradation of resolution since it has been found that interlayer residues occur, degrading resolution when such a thermal treatment disclosed in the prior art is used in such a process.

However, where a novolac top resist layer is used and the bottom resist layer is an aqueous base developable resist layer, the material can be developed immediately without any further treatment such as a thermal treatment. Alternatively, if desired, the imaging material after exposure imagewise can be subjected to a thermal treatment such as a baking at a temperature of 100°C to about 200°C, preferably 120 to 150°C, for a period of about 1 to 10 minutes, preferably 5 to 10. An intermediate plasma hardening treatment, in place of a blanket exposure for opacification can be employed, using techniques well known in the art for plasma hardening treatment of resist layers as disclosed in U.S. Patent 4,187,331; J. Moran and G. Taylor, J. Vac. Sci. & Tech., 19:1127 (1981), can be employed, if desired.

Thus, these embodiments of this invention are not dependent on U.V. hardening of the novolac resist when an aqueous base developable bottom resist layer is used. Any hardening technique which allows a subsequent high temperature bake can be used, including plasma hardening as is presently practiced in the art. Reference is also made to U.S. Patents 4,187,331 and 4,253,388 for a description of plasma hardening techniques. Since the mask layer is typically 1.0 micron or less in thickness, plasma hardening is more effective utilizing these embodiments of the process of this invention than typically reported in the literature for an imaging material of this layer structure.

The following examples are given to illustrate the present invention in greater detail. However, these examples are not to be construed as limiting the scope of the present invention. Unless otherwise indicated herein, all parts, percents, ratios and the like are by weight.

Example 1

A Si wafer with a thermally grown oxide layer of a thickness of 500 nm was coated with 1.7 μm layer of an acrylic terpolymer resist (a terpolymer of methyl methacrylate, methacrylic anhydride and methacrylic acid; molar ratio: 70:15:15), overcoated with 0.5 μm layer of a diazoquinone/novolac photoresist and baked at 80°C for 30 minutes. The top layer resist was patterned by exposure on a GCA 6000 step and repeat camera (commercially available from G.C.A. Corporation) followed by development in an aqueous solution of 0.2N KOH for 1.5 minutes at a temperature of 23°C. The 280 - 310 nm U.V. treatment of this patterned masking layer was carried out using a Microlite 100m - (available from Fusion Semiconductor Systems, Inc.) with a 280 nm cutoff filter. The U.V. treatment time was 800 seconds. Following this, the underlying deep U.V. resist was exposed to light of a wavelength of 200 to 240 nm using the above camera and developed in a dilute solution (about 1 wt%) of tetramethylammonium hydroxide. Good quality submicron (0.8 micron) images were obtained.

Comparative Example 1

On an identical Si wafer produced as described in Example 1 and subjected to the procedures of Example 1 except no 280 to 310 nm U.V. exposure treatment was employed, the resolution was limited to about 1.2 or 1.1 μm. Few of the 1 micron images and none of the submicron images were resolved.

Example 2

Si wafers with a thermally grown oxide layer of a thickness of 500 nm were coated with 1.7 μm of an acrylic terpolymer resist as disclosed in Example 1 and then baked at 200°C. This layer of each wafer was overcoated with a diazoquinone/novolac photoresist layer as in Example 1. The novolac photoresist layer was imagewise exposed using a Kasper contact aligner (NUV) with 75 mJ/cm² followed by development in a 0.20N KOH aqueous developer.

Then, the wafers with the patterned and developed novolac resist layer were exposed to 300 nm radiation (35 mw/cm²) using a 300 nm light source (Optical Associates, Inc.) using a 280 nm cutoff filter for 600 seconds to opacify the novolac resin image in the 240 -280 nm region.

One Si wafer thus obtained was then thermally treated at 150°C for 10 minutes and a second wafer so obtained was so thermally treated followed by an additional thermal treatment at 180°C for 5 minutes.

Subsequently, the bottom resist layer was exposed through the patterned and baked top novolac resist exposure to wavelength of 200-250 nm at 1500 mJ/cm² using a Microlite 100 m radiation source employing a 230 nm dielectric mirror. The acrylic terpolymer resist layer of each of the sam-

ples obtained above was then developed with a 1:1.15 (by volume) dilution of 0.32N tetramethyl ammonium hydroxide (Acculith LMI600 produced by Allied Corporation) and a clear image with no evidence of interlayer residues was obtained in each.

The results above show that by use of the combination of a U.V. exposure followed by a thermal treatment for opacity improvement of the novolac resin resist to U.V. light, clean development of the underlying acrylic terpolymer resist layer can be obtained and any interfacial residues are clearly removed by development by the acrylic terpolymer underlying deep U.V. resist layer using a non-polluting aqueous base developer.

Comparative Example 2

Si wafers as described in Example 2 were produced except that a polymethyl methacrylate - (PMMA) resist layer was employed instead of the acrylic terpolymer resist layer as the bottom resist layer and the PMMA was heated at 160°C for 30 minutes prior to coating thereon on the top diazoquinone/novolac resist layer. The novolac resist layer on each of the Si wafers then was imagewise exposed as described in Example 2.

One Si wafer (Sample 1) so exposed was thermally treated at 150°C for 10 minutes and a second Si wafer (Sample 2) was thermally treated at 150°C for 10 minutes followed by treatment at 180°C for 5 minutes.

The underlying PMMA resist layer was then exposed through the patterned novolac resist using a Microlite 100 m radiation source at 1500 mJ/cm² at 230 nm as described in Example 2.

The so exposed PMMA resist layer of Sample 1 was developed in methyl isobutyl ketone (MIBK) for 75 seconds to remove the exposed region of the PMMA. However, interfacial residues between the PMMA layer and the novolac layer remained in the image areas.

An additional 25 second development with MIBK did not remove the interfacial residues. Use of isopropyl alcohol (IPA) as a rinse was also found not to remove the interfacial residues.

On Sample 2, the so exposed PMMA resist layer was developed for 90 seconds in MIBK to remove the PMMA, but still an extremely high level of interfacial residues remained.

Example 3

Si wafers coated with resists as described in Comparative Example 2 were prepared and the procedures of Comparative Example 2 were followed but without any thermal treatment after the first imagewise exposure and development procedures of Comparative Example 2. After the second imagewise exposure step, PMMA development in MIBK for 90 minutes was conducted to give clear images without interfacial residues. Although the novolac resist layer patterns were not removed and remained capped, some image deformation occurred.

When the above procedures of this example were repeated except that a mixed solvent of acetone/isopropyl alcohol and water (60:40:3 parts by volume) was used instead of the MIBK, the novolac resist layer patterns were removed to provide uncapped interfacial residue-free images in the PMMA resist.

This invention, therefore, greatly improves manufacturing techniques employing PCM technology. Using this invention, an inexpensive alternative to RIE processes for sub-etch and lift-off applications is provided.

While the invention has been described in detail and with reference to specific embodiments thereof, it will be apparent to one skilled in the art that various changes and modifications can be made therein without departing from the spirit and scope thereof.

## Claims

1. Method to provide enhanced opacity in a novolacbased imaging mask, comprising

(a) providing a substrate with an aqueous base developable deep U.V. resist bottom layer sensitive to wavelengths in the range from about 200 to below about 280 nm with a novolac resin based resist top layer;

(b) imagewise exposing said top resist layer;

(c) developing said imagewise exposed top resist layer for conversion thereof into said imaging mask;

(d) imagewise exposing said bottom resist layer through said imaging mask with U.V. light containing wavelengths in the range of about 200 to about 280 nm; and

(e) developing said bottom resist layer with an aqueous base developer to form an image conforming to the image of said imaging mask.

2. Method of claim 1, wherein said bottom resist layer. comprises an aqueous base developable acrylic or methacrylic polymer, aliphatic imide polymer, itaconic acid polymer or poly-(hydroxystyrene). .

3. Method of claim 2, wherein said aqueous base developable acrylic or methacrylic polymer is a terpolymer of methyl methacrylate, methacrylic acid and methacrylic anhydride.

4. Method of claim 1, wherein said novolac resin based top resist layer includes a sensiztizer.

5. Method of claim 4, wherein said sensitizer is selected from the group of 1,2-diazonaphthoquinone-5-sulfonate, an arylazido or bis-arylazido compound, or a polyolefin sulfone.

6. Method of claim 1, wherein between said developing in step (c) and said imagewise exposing in step (d), said method comprises exposing said imaging mask with radiation having wavelengths in the range of about 280 to about 310 nm.

7. Method to provide enhanced opacity in a novolac-based imaging mask comprising:

    (a) providing a substrate with an organic solvent developable deep U.V. resist bottom layer sensitive to wavelengths in the range from about 200 to below about 280 nm and with a novolac resin based resist top layer;

    (b) imagewise exposing said top resist layer;

    (c) developing said imagewise exposed top resist layer for conversion thereof into said imaging mask;

    (d) exposing said imaging mask with radiation having wavelengths in the range of about 280 to 310 nm;

    (e) imagewise exposing said bottom resist layer through said imaging mask with U.V. light containing wavelengths in the range of about 200 to about 280 nm; and

    (f) without further treating said imaging mask, developing said bottom resist layer with an organic solvent developer to form an image corresponding to the image of said imaging mask.

8. Method of claim 7, wherein said bottom resist layer comprises an organic solvent developable acrylic or methacrylic polymer or polymethyl isopropyl ketone.

9. Method of claim 8, wherein said organic solvent developable acrylic polymer is polymethylmethacrylate.

10. Method of producing a resist comprising:

    (a) providing a substrate with a bottom layer of a first resist material sensitive to wavelengths in the range of about 200 to about 300 nm and a top layer of a second resist material sensitive to wavelengths in the range of about 300 to about 500 nm, wherein

    (i) the first resist material and the second resist material each becomes developable in an aqueous base developer upon exposure to radiation to which said resist material is sensitive or upon exposure to radiation to which said resist material is sensitive followed by thermally treating the resist material,

    (ii) The top layer resist material uniformly coats and adheres with the bottom layer resist material,

    (iii) the first resist material and the second resist material are sensitive to radiation in substantially different wavelength ranges or are differentially sensitive to radiation in the same wavelength range with the second resist material being at least about 100 times more sensitive to such radiation than the first resist material and

    (iv) after exposure and development of the top layer, the top layer resist material acts as an effective mask for radiation of wavelengths to which the bottom layer resist material is sensitive;

    (b) imagewise exposing the top resist layer to radiation within a wavelength range to which the top layer resist material is sensitive;

    (c) developing the imagewise exposed top resist layer with an aqueous base developer for conversion thereof into an imaging mask;

    (d) imagewise exposing the bottom resist layer through the imaging mask to radiation within a wavelength range to which the bottom layer resist material is sensitive; and

    (e) developing the bottom resist layer with an aqueous-base developer to form an image conforming to the image of the imaging mask.

11. Method of claim 10, wherein said bottom layer comprises a layer of an aqueous base developable acrylic or methacrylic polymer.

12. Method of claim 11, wherein said resist materials are selected from the group consisting of:

    (1) a polymer which contains a carboxylic acid group and which upon irradiation becomes aqueous-base developable;

    (2) a polymer comprising an acid anhydride group wherein upon irradiation the anhydride hydrolyzes, or after irradiation, in the presence of the aqueous base developer, the anhydride hydrolyzes to provide an acid;

    (3) a polymer comprising an imide group upon which irradiation becomes aqueous-base developable; and

(4) a polymer which upon irradiation generates a phenolic or hydroxy group.

13. Method of claim 10, wherein said top resist layer is a layer of a novolac resin, a polyvinyl phenol polymer or a polymer convertable thereto upon irradiation or upon irradiation and thermal treatment.

14. Method of claim 10, wherein said top resist layer includes a sensitizer selected from the group of 1,2-diazonaphthoquinone-5-sulfonate, polyolefin sulfone, or an onium salt compound.

15. Method of claim 10, wherein prior to said imagewise exposing of step (d) said method comprises subjecting said imaging mask to a thermal treatment, or to a plasma hardening treatment and a thermal treatment respectively.

16. Method of claim 10, wherein said radiation of exposure for said top layer resist material is X-rays, electron beams or ion beams.

FIG.1

FIG.2

UV HARDENED
30' EXPOSURE

BAKED 200°C
30'

PLASMA
HARDENED

FIG.3

0 197 519